# EUROPEAN PATENT SPECIFICATION

(11) **EP 0 486 845 B1**
(45) Date of publication and mention of the grant of the patent: **28.08.1996**
(21) Application number: 91118300.2
(22) Date of filing: 26.10.1991
(51) Int. Cl.: H01R 9/09, H01R 23/72

(54) **Electrical connector with solder mask**
Elektrischer Verbinder mit Lötmaske
Connecteur électrique avec masque de soudure

(30) Priority: 19.11.1990 US 615511
(43) Date of publication of application: 27.05.1992
(73) Proprietor: MOLEX INCORPORATED, Lisle Illinois 60532 (US)
(72) Inventor: Berg, B. Alan, Singapore 1026 (SG); Kachlic, Jerry D., Singapore 2159 (SG)
(74) Representative: Blumbach, Kramer & Partner

(56) References cited:
- EP-A- 0 083 471
- EP-A- 0 280 450
- EP-A- 0 280 508
- DE-B- 1 465 176
- US-A- 3 673 551
- US-A- 4 010 992
- US-A- 4 114 008

## Description

### Field of the Invention

This invention generally relates to the art of electrical connectors and particularly to a connector for mounting to a printed circuit board and including solder mask means to prevent solder from entering holes in the printed circuit board during soldering of terminals to circuit traces on the board according to the preamble of claim 1.

### Background of the Invention

Many electrical connectors conventionally are fabricated with a dielectric housing, such as molded of plastic material, for mounting a plurality of electrical terminals, such as stamped and formed metal contacts. One such connector may comprise a receptacle for mating with a plug connector, sometimes called female and male connector components. The terminals, likewise, may be formed as receptacle terminals for receiving pin terminals from the mating connector. Such a type of connector is shown e.g. in EP 0 083 471 A1.

Electrical connectors of the character described above desirably have various characteristics such as reliable contact forces between the terminals in a transverse direction and, in some instances, anti-overstress protection for flexible portions of the stamped and formed terminals. It may be desirable for the receptacle connector and receptacle terminal to be capable of accepting a mating plug connector and pin terminal to be capable of accepting a mating plug connector and pin terminal from either direction, sometimes called "top and bottom" mating. When such connectors are used as headers, such as for surface mounting on a printed circuit board, it often is desirable that the connectors have a low profile in a direction transverse to the board.

One of the problems with electrical connectors or headers of the character described above involves solder contamination of the terminals during manufacture or processing of the connectors. In particular, when the terminals are female or receptacle terminals, solder tails are provided for insertion into holes in the printed circuit board. When the terminals are soldered to circuit traces or plated-through holes in the board, there is a tendency for some of the solder to flow into the housing which would contaminate or render inoperable the receptacle portion of the terminal. This is particular true of housings in which a complementary pin terminal is inserted into the receptacle terminal from below the printed circuit board.

For instance, a typical soldering method is called wave soldering, wherein the printed circuit board is passed through a molten solder wave that contacts the surface of the printed circuit board to establish solder connections between the solder tails of the receptacle terminal and the plated-through holes or the circuit traces on the printed circuit board surface. Normally, due to capilary action solder flows into the holes or any space left between the solder tails and the holes, with a possibility that the solder could enter the housing or build up on the solder tail and thus contaminate the receptacle portions of the terminals which would prevent a good electrical connection with complementary pin terminals. An example of an approach to prevent solder contamination as described above, is to provide a solder mask as shown in U.S. patent no. 4,750,889 to Ignasiak et al. dated June 14, 1988 and EP 0 280 508 A2. This patent shows a through-board electrical component header having an integral solder mask means in the form of masking pins integrally attached to a body of the connector for insertion into the holes in the printed circuit board to completely block the openings and prevent solder from entering the holes. However, the solder masking pins, after the soldering process has been completed, must be removed in order to gain access to the receptacle portions of the terminals within the header body. In essence, the solder masking pins must be provided with some form of frangible means or portions to facilitate their removal. Such a system thus requires an additional step in the processing and mounting of the header to the printed circuit board before the assembly is ready for use. Such additional processing step adds to the expense and complexity of the assembly.

This invention is directed to solving the above problems by an improved solder masking technique which is processed using the same manufacturing procedures of non-solder masked connectors mounted to a printec circuit board.

### Summary of the Invention

An object, therefore, of the invention is to provide an electrical connector for mounting to a printed circuit board with a new and improved solder masking means for preventing solder from blocking entry to the holes in the printed circuit board and protecting the contact from solder.

In the exemplary embodiment of the invention, the electrical connector, or header, includes an insulating housing having a body with a through cavity for receiving an electrical terminal to be soldered to a circuit trace on the printed circuit board. A solder masking hollow peg projects from one side of the body for insertion in a hole in the printed circuit board for preventing solder from entering the hole during soldering of the electrical terminal to the circuit trace on the printed circuit board. The interior of the hollow peg communicates with the through cavity in the body to allow a mating terminal to be inserted through the hollow peg into contact with the terminal inside the body.

As disclosed herein, the hollow peg projects slightly beyond the printed circuit board on a side thereof opposite the side of the board to which the housing is mounted. The body includes an opening outside the peg through which a solder tail of the electrical terminal projects. The terminal includes a receptacle portion in the through cavity of the body for receiving a mating terminal inserted through the hollow peg.

Other objects, features and advantages of the invention will be apparent from the following detailed description taken in connection with the accompanying drawings.

### Brief Description of the Drawings

The features of this invention which are believed to be novel are set forth with particularity in the appended claims. The invention, together with its objects and the advantages thereof, may be best understood by reference to the following description taken in conjunction with the accompanying drawings, in which like reference numerals identify like elements in the figures and in which:
FIGURE 1 is a plan view of an electrical connector incorporating the features of the present invention;
FIGURE 2 is an elevational view of the connector housing, partially in section as along line 2-2 of Figure 1, with the terminals shown in elevation;
FIGURE 3 is a vertical section taken generally along line 3-3 of Figure 1, with the terminals shown in elevation;
FIGURE 4 is an end view looking in a direction through the pin receiving opening of one of the terminals of the invention;
FIGURE 5 is a vertical section taken generally along line 5-5 of Figure 4, with the terminal shown still attached to a web of a blank from which the terminal is stamped and formed;
FIGURE 6 is a section, on an enlarged scale, through one of the contact detents of the terminal;
FIGURE 7 is an illustration of one of the terminals as being stamped from a metal blank, prior to forming; and

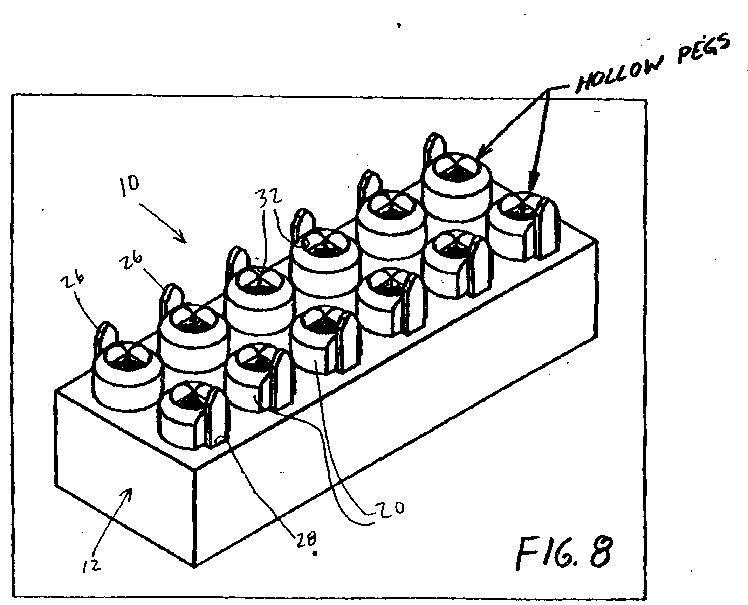

FIGURE 8 is a perspective view of the electrical connector of the present invention.

### Detailed Description of the Preferred Embodiment

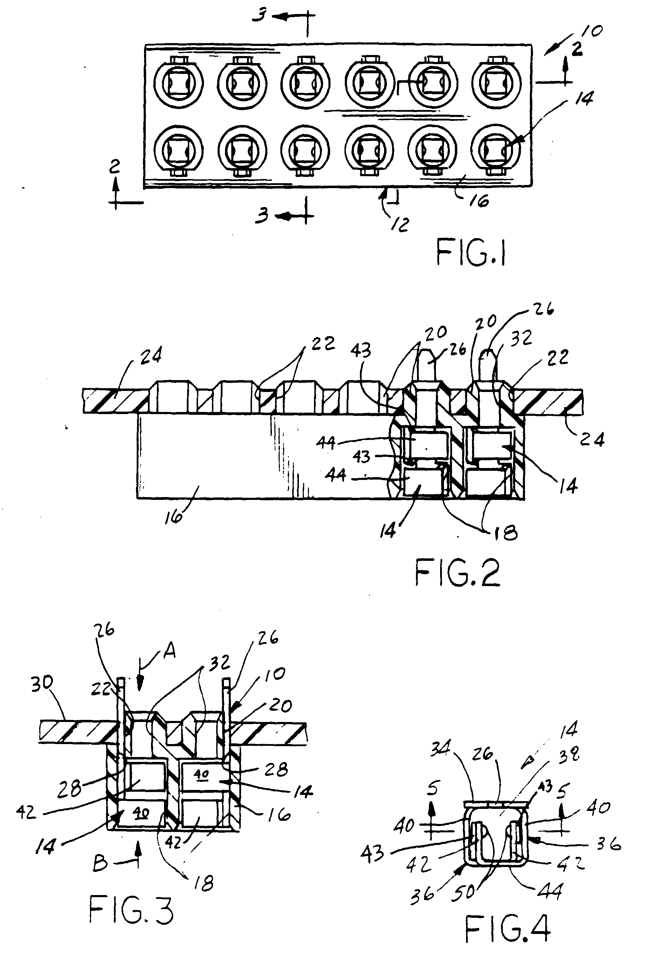

Referring to the drawings in greater detail, and first to Figures 1-3, the invention is illustrated as embodied in an electrical connector, generally designated 10, which includes a dielectric housing, generally designated 12, for receiving a plurality of receptacle contacts or terminals, generally designated 14, which embody the concepts of the invention.

Housing 12 includes a body 16 having a plurality of cavities 18 which receive terminals 14. A plurality of hollow pegs 20 project upwardly from body 16 for insertion through appropriate holes 22 in a printed circuit board 24 to which the connector is mounted.

As seen in Figure 3, an opening 28 in body 16, outside of each peg 20, is provided and through which a solder tail 26 (described hereinafter) of a respective terminal 14 extends through the respective hole 22 in circuit board 24. The solder tail is appropriately connected by soldering to circuit traces on side 30 of the circuit board or to through plating in the holes in the board.

As seen in Figures 2 and 3, hollow pegs 20 project slightly beyond the side 30 of printed circuit board 24 opposite the side of the board to which body 16 is mounted. With solder tails 26 projecting through the printed circuit board on the outside of hollow pegs 20, the solder tails are exposed exteriorly of the hollow pegs for soldering to circuit traces on the opposite side of the printed circuit board or to through plating in the holes in the board. The soldering may be carried out by conventional wave soldering techniques wherein a molten solder wave contacts the opposite side 30 of the printed circuit board to solder the solder tails to the circuit traces or hole plating. With the hollow pegs projecting beyond the opposite side 30 or surface of the printed circuit board and solder tail 26 being positioned outside of bore 32, as shown in Figures 2 and 3, the solder wave is sufficiently blocked from entering the distal ends of the pegs and into the cavities 18 in body 16 where the solder would, otherwise, contaminate the terminals within the cavities.

Terminals 14 will be described in greater detail, but in the context of connector 10 in Figures 1-3, the terminals are designed for receiving contact pins (not shown) insertable into housing 12 from a mating or complementary connector either from the top of the connector 10, as shown by arrow "A" (Fig. 3) through a bore 32 in each peg 20, or from the bottom of the connector, in the direction of arrow "B", into contact with a terminal disposed within the respective cavity in the housing. It should be understood that the above description of surface mounted connector 10 on a printed circuit board 24 is but one example of using the novel terminal 14 of the invention. The terminal is equally applicable for use in other types of connectors.

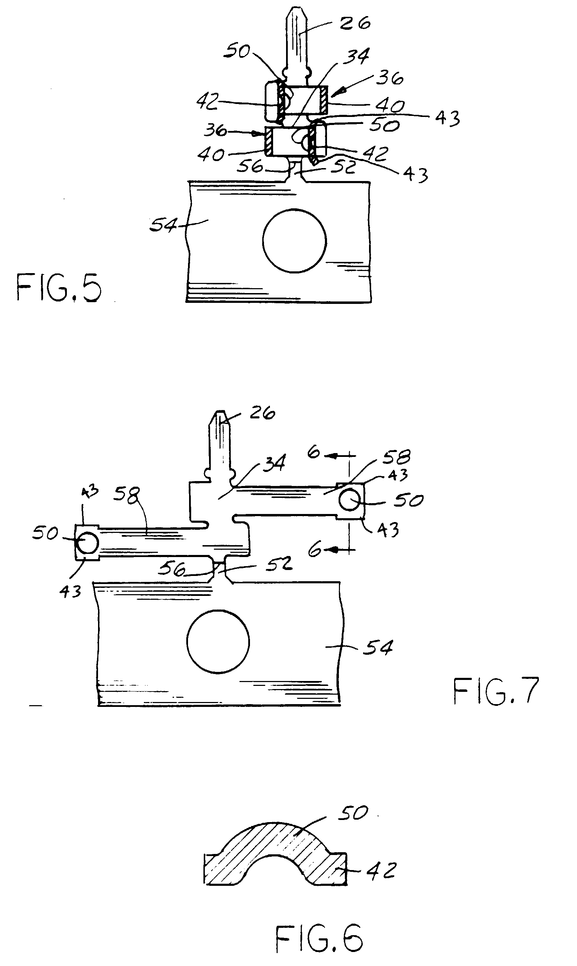

More particularly, referring to Figures 4 and 5, each terminal 14 includes a generally flat base 34 from which solder tail 26 extends in a coplanar manner. The terminal includes a pair of generally U-shaped members, generally designated 36, which combine to define a contact pin receiving opening 38 (Fig. 4).

Each U-shaped member 36 includes a first leg 40 fixed to and projecting generally perpendicularly from base 34, a second or free leg 42 projecting back toward base 34, and a bight portion 44 joining legs 40,42. It can be seen in Figure 5 that U-shaped members 36 are spaced longitudinally of the terminal (i.e., longitudinally of opening 38 and solder tail portion 26) and are reversed in orientation. To this end, it can be seen that the first legs 40 are disposed laterally outwardly of the second legs 42 of the other U-shaped members. This lateral spacing or disposition allows for flexing of free legs 42 when a contact pin is inserted into opening 38.

Referring to Figure 6, in conjunction with Figures 4 and 5, leg 42 of each U-shaped member 36 is provided with an inwardly projecting contact detent or dimple 50 which establishes engagement and electrical contact with a mating terminal pin inserted into opening 38.

Figure 5 shows base 34 of terminal 14 connected by a web 52 to a strip 54 of a metal blank from which the terminal is stamped and formed. This is shown in Figure 5 simply for illustration purposes. Line 56 represents a score line at which the terminal is severed for insertion into a respective cavity 18 of housing 12.

More particularly, Figure 7 shows the components of terminal 14 after having been stamped from a continuous metal blank and with contact detents 50 stamped into distal ends of longitudinally running strips 58 of the blank. Each strip 58 subsequently is formed into the U-shaped members 36 described above. Base 34 and coplanar solder tail 26 are shown in Figure 7 as having been stamped from the metal blank into the ultimate shapes thereof in the stamped and formed terminal described above in relation to Figures 4 and 5.

From the foregoing, it can be seen that an electrical terminal 14 has been provided to define a contact pin-receiving receptacle. The terminal, with U-shaped members 36, provides a very low profile (i.e., longitudinally of the terminal) to facilitate the provision of a very low profile connector 10. The terminal and the connector can be mated with a complementary connector or header from either the top or bottom thereof. Free legs 42 of the U-shaped members provide for high pressure contact reliability, and formed portion 43 of the U-shaped members provide anti-overstress protection for the terminal when a pin is inserted thereinto through opening 38.

It will be understood that the invention may be embodied in other specific forms . The present examples and embodiments, therefore, are to be considered in all respects as illustrative and not restrictive, and the invention is not to be limited to the details given herein, but only by the scope of the appended claims.

## Claims

1. An electrical connector (10) for mounting to a face of a printed circuit board (24) having a plurality of holes (22), said connector comprising an insulating housing (12) including a body (16) having a plurality of cavities (18) for receiving an electrical terminal (14) therein, with a portion (26) of each terminal connected to a circuit trace on the printed circuit board, each cavity being aligned and in communication with one of said holes to permit a mating terminal to be inserted through said hole (22) and into said cavity (18) to mate with said electrical terminal (14), said housing (12) being positionable so that said printed circuit board (24) and said housing (12) are generally adjacent, wherein
a plurality of solder masking pegs (20) project from said housing (12) for insertion in said plurality of holes (22) for preventing solder from entering the holes during soldering of said electrical terminals to the circuit traces on the printed circuit board (24),
characterized in that
said pegs (20) are hollow and each interior (32) thereof is aligned and communicates with an assigned-to one of said cavities (18) in the housing (12) when mounted to said printed circuit board (24) to allow said mating terminals to be inserted through said hollow pegs (20) and into contact with the terminal (14) inside the housing.

2. The electrical connector of claim 1
wherein said hollow peg projects beyond the face of the printed circuit board.

3. The electrical connector of claim 1 or 2
wherein said housing (12) includes an opening (28) outside the peg (20) through which a solder tail (26) of the electrical terminal (14) projects.

4. The electrical connector of claim 1, 2 or 3
wherein said housing (12) is configured so that said mating terminals can enter said housing through either said printed circuit board or from the opposite side in order to mate with said terminals.

5. The electrical connector of claim 1
wherein said electrical terminal includes a base (34) and a pair of U-shaped members (36) which define a contact pin receiving opening, one leg (40) of each U-shaped member being fixed to and projecting from the base and the other leg (42) being free and projecting back toward the base, the U-shaped members being spaced longitudinally of the opening and reverse in orientation.

6. The electrical connector of claim 1
wherein each said hollow peg (20) is dimensioned so as to be approximately the same diameter as its mating hole (22) in the printed circuit board (24).

7. The electrical connector of claim 1
wherein said housing (12), including said body (16) and hollow peg (20), are fabricated of unitarily molded dielectric material.

## Patentansprüche

1. Elektrischer Steckverbinder (10), der auf der Vorderseite einer mit mehreren Löchern (22) versehenen Leiterplatte (24) anbringbar ist und ein isolierendes Gehäuse (12) mit einem Hauptteil (16) umfaßt, das mit mehreren Kammern (18) zur jeweiligen Aufnahme einer elektrischen Klemme (14) versehen ist, wobei ein Klemmenteil (26) mit einer Leiterbahn auf der Leiterplatte verbunden ist, wobei ferner die Kammern zu den zugehörigen Löchern (22) ausgerichtet sind und mit diesen in Verbindung stehen, so daß eine Gegenklemme durch das betreffende Loch (22) in die Kammer (18) einführbar ist, um mit einer elektrischen Klemme (14) einen Kontakt herzustellen, wobei das Gehäuse (12) so positionierbar ist, daß die Leiterplatte (24) und das Gehäuse (12) im großen und ganzen benachbart zueinander angeordnet sind, und wobei von dem Gehäuse (12) mehrere Lötmaskenzapfen (20) so vorstehen, daß sie in die Löcher (22) einführbar sind, damit beim Verlöten der elektrischen Klemmen mit den Leiterbahnen der Leiterplatte (24) kein Lötmittel in die Löcher eindringt,
dadurch gekennzeichnet,
daß die Zapfen (20) hohl ausgebildet sind, und daß das Zapfeninnere (32) beim Anbringen des Gehäuses (12) an der Leiterplatte (24) jeweils zu einem zugeordneten Loch (18) ausgerichtet ist, und so mit diesem in Verbindung steht, daß die Gegenklemmen durch die hohlen Zapfen (20) eingeführt und in Kontakt mit den Klemmen (14) im Inneren des Gehäuses gebracht werden können.

2. Elektrischer Steckverbinder nach Anspruch 1, bei dem die hohl ausgebildeten Zapfen über die Vorderseite der Leiterplatte vorsteht.

3. Elektrischer Steckverbinder nach Anspruch 1 oder 2, bei dem das Gehäuse (12) außerhalb des Zapfens (20) eine Öffnung (28) umfaßt, durch die eine Lötfahne (26) der elektrischen Klemme (14) vorsteht.

4. Elektrischer Steckverbinder nach Anspruch 1, 2 oder 3, bei dem das Gehäuse (12) so gestaltet ist, daß die Gegenklemmen entweder durch die Leiterplatte oder von der gegenüberliegenden Seite aus in das Gehäuse einführbar sind, um einen Kontakt mit den Klemmen herzustellen.

5. Elektrischer Steckverbinder nach Anspruch 1, bei dem die elektrische Klemme ein Basisteil (34) und zwei U-förmige Teile (36) umfaßt, die eine Aufnahmeöffnung für einen Kontakt- oder Steckerstift bilden, wobei bei den U-förmigen Teilen jeweils ein Schenkel (40) an dem Basisteil befestigt ist, daß er von diesem vorsteht, während der andere Schenkel (42) jeweils frei ist und in Richtung auf das Basisteil nach hinten vorsteht, und wobei die U-förmigen Teile in Längsrichtung der Öffnung zueinander beabstandet und umgekehrt zueinander ausgerichtet sind.

6. Elektrischer Steckverbinder nach Anspruch 1, bei dem die hohlen Zapfen (20) jeweils so bemessen sind, daß sie näherungsweise in etwa den gleichen Durchmesser aufweisen# wie die zugehörigen Gegenlöcher (22) in der Leiterplatte (24).

7. Elektrischer Steckverbinder nach Anspruch 1, bei dem das Gehäuse (12) mit dem Hauptteil (16) und den hohlen Zapfen (20) aus einem einstückig geformten oder gegossenen dielektrischen Material besteht.

## Revendications

1. Connecteur électrique (10) pour montage sur une face d'une carte à circuit imprimé (24) comportant une pluralité de trous (22), ledit connecteur comprenant un boîtier isolant (12) incluant un corps (16) comportant une pluralité de cavités (18) pour y recevoir une borne électrique (14), une partie (26) de chaque borne étant connectée à un ruban de circuit sur la carte à circuit imprimé, chaque cavité étant alignée et en communication avec l'un desdits trous pour permettre d'introduire une borne complémentaire par ledit trou (22) dans ladite cavité (18) pour l'accoupler avec ladite borne électrique (14), ledit boîtier (12) pouvant être placé de façon telle que ladite carte à circuit imprimé (24) et ledit boîtier (12) soient globalement adjacents, dans lequel :
une pluralité de tenons de masquage de soudure (20) dépassent dudit boîtier (12) pour introduction dans ladite pluralité de trous (22) pour empêcher la soudure de pénétrer dans les trous pendant le soudage desdites bornes électriques aux rubans de circuit sur la carte à circuit imprimé (24);
caractérisé :
en ce que lesdits tenons (20) sont creux et en ce que l'intérieur (32) de chacun d'eux est aligné et communique avec l'une desdites cavités (18) dudit boîtier (12) qui lui est affectée, lorsqu'il est monté sur ladite carte à circuit imprimé (24), pour permettre d'introduire lesdites bornes complémentaires à travers lesdits tenons creux (20) et de les mettre en contact avec la borne (14) à l'intérieur dudit boîtier.

2. Connecteur électrique selon la revendication 1, dans lequel ledit tenon creux dépasse au-delà de la face de la carte à circuit imprimé.

3. Connecteur électrique selon la revendication 1 ou 2, dans lequel ledit boîtier (12) comprend une ouverture (28) à l'extérieur du tenon (20) par laquelle dépasse une queue à souder (26) de la borne électrique (14).

4. Connecteur électrique selon la revendication 1, 2 ou 3, dans lequel ledit boîtier (12) est conformé de façon telle que lesdites bornes complémentaires puissent pénétrer dans ledit boîtier soit à travers ladite carte à circuit imprimé soit du côté opposé, afin de s'accoupler avec lesdites bornes.

5. Connecteur électrique selon la revendication 1, dans lequel ladite borne électrique comprend une base (34) et une paire d'éléments en forme de U (36) qui définissent une ouverture de réception de broche de contact, une jambe (40) de chaque élément en forme de U étant fixée à la base et dépassant de celle-ci, et l'autre jambe (42) étant libre et dépassant en arrière vers la base, les éléments en forme de U étant espacés longitudinalement de l'ouverture et étant orientés en sens inverses.

6. Connecteur électrique selon la revendication 1, dans lequel chacun desdits tenons creux (20) est dimensionné de façon à avoir à peu près le même diamètre que son trou complémentaire (22) dans la carte à circuit imprimé (24).

7. Connecteur électrique selon la revendication 1, dans lequel ledit boîtier (12), comprenant ledit corps (16) et ledit tenon creux (20), sont faits d'une matière diélectrique moulée d'une seule pièce.
